# EUROPEAN PATENT APPLICATION

(11) **EP 4 372 467 A1**
(43) Date of publication of application: **22.05.2024**
(21) Application number: 22208395.8
(22) Date of filing: 18.11.2022
(51) Int. Cl.: G03F 7/20, H01L 21/683

(54) **OBJECT HOLDER AND MANUFACTURING METHOD**

(71) Applicant: ASML Netherlands B.V., 5500 AH Veldhoven (NL)
(72) Inventor: VAN DRENT, William, Peter, 5500 AH Veldhoven (NL)
(74) Representative: ASML Netherlands B.V.

(57) **Abstract**

An object holder is configured to support an object. The object holder comprises a core body (61) comprising a plurality of burls (62) having distal ends (63) in a support plane (64) for supporting the object. The object holder further comprises an electrostatic sheet (65) between the burls. The electrostatic sheet comprises an electrode (66) comprising a metal, and metal oxide layers (67,68) comprising an oxide of the metal. The electrode is sandwiched between the metal oxide layers.

## Description

### FIELD

The present invention relates to an object holder, an object table comprising such object holder, a lithographic apparatus comprising such object holder, and a method of manufacturing such object holder.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

An object, such as a substrate or a mask, may be held by an object holder. Due to high accelerations of the object, such as the substrate or mask, the object holder is configured to clamp the object. For example, vacuum clamping may be used, whereby a space between the object and the object holder is evacuated or partially evacuated, so that a pressure of gas at an opposite surface of the object pushes the object against the holder. However, the lithographic apparatus which uses EUV radiation may operate in a vacuum or a near vacuum, i.e. at a low pressure. In such lithographic apparatuses, vacuum clamping may be unsuitable, for which reason electrostatic clamping may be used. The lithographic apparatus may comprise an electrostatic object holder which is configured to hold an object by an electrostatic force. The electrostatic object holder may comprise a plurality of burls having distal ends in a support plane for supporting the object, and an electrostatic sheet between the burls, wherein the electrostatic sheet is configured to be electrically charged so as to exert an electrostatic clamping force on the object held by the burls.

### SUMMARY

An object of the present invention is to provide an improved object holder.

According to an aspect of the present invention, there is provided an object holder configured to support an object, the object holder comprising:
a core body comprising a plurality of burls having distal ends in a support plane for supporting the object; and an electrostatic sheet between the burls, the electrostatic sheet comprising an electrode comprising a metal, and metal oxide layers comprising an oxide of the metal, wherein the electrode is sandwiched between the metal oxide layers.

According to another aspect of the invention, there is provided an object table comprising a supporting member and the object holder according to an aspect of the invention, the object holder being attached to the supporting member.

According to yet another aspect of the invention, there is provided a lithographic apparatus arranged to project a pattern from a patterning device onto a substrate, the lithographic apparatus comprising the object holder according to an aspect of the invention or the object table according to an aspect of the invention.

According to a still further aspect of the invention, there is provided a method of manufacturing an object holder, comprising:
providing a metal sheet comprising a metal, creating a plurality of through holes in the metal sheet, providing metal oxide layers on the metal sheet to form an electrostatic sheet, the metal oxide layers comprising an oxide of the metal, providing a core body comprising a plurality of burls having distal ends in a support plane for supporting the object, and assembling the electrostatic sheet and the core body to form the object holder.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a cross sectional view of a part of an object holder for a lithographic apparatus;
- Figure 3 depicts a cross sectional view of a part of another embodiment of the object holder;
- Figures 4 and 5 depict stages of manufacturing the object holder as depicted in Figures 2 and 3;
- Figure 6 depicts a cross sectional view of a part of an object holder according to an embodiment of the invention;
- Figure 7 depicts a cross sectional view of a part of an object holder according another embodiment of the invention; and
- Figure 8 depicts a cross sectional view of another part of the object holder in accordance with the present invention.

### DETAILED DESCRIPTION

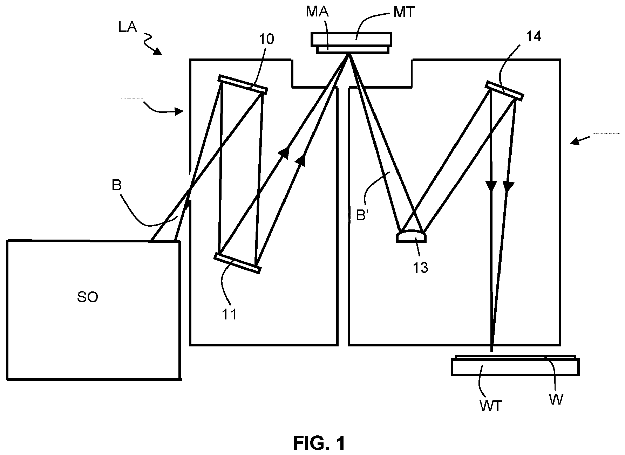

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS. In another embodiment, hydrogen may be provided in a compartment where the substrate table WT is provided.

The radiation source SO may be a laser produced plasma (LPP) source, a discharge produced plasma (DPP) source, a free electron laser (FEL) or any other radiation source that is capable of generating EUV radiation.

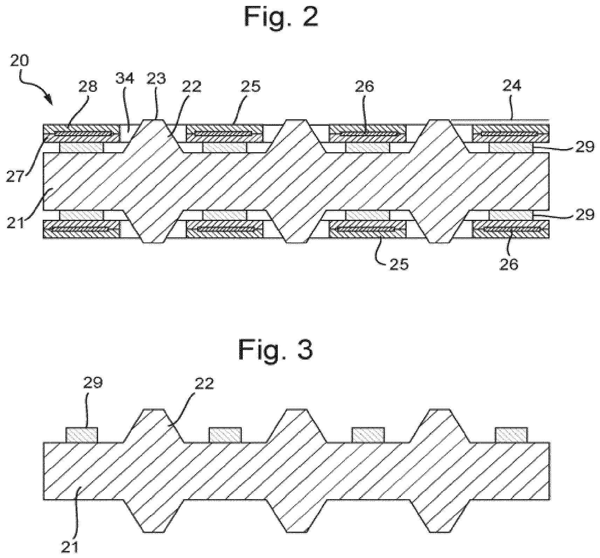

Figure 2 is a cross-sectional view of an object holder 20 for a lithographic apparatus. The object holder 20 is configured to support an object. In the description below, the invention will be described in a context of the object holder being a substrate holder 20 that is configured to support a substrate W. However, the object holder is not limited to such a substrate holder 20. For example, the object holder may be configured to support a patterning device MA, such as a mask.

In an embodiment, the substrate Table WT comprises the substrate holder 20 and a substrate stage. For example, the substrate stage may comprise a recess into which the substrate holder 20 is held. The substrate holder 20 is configured to hold the substrate W relative to the substrate stage of the substrate table WT. As another example, the mirror block of the substrate stage may have a flat top without cutout for the clamp. The bottom electrode of the clamp may exert a clamping force on the mirror block to hold the clamp in place on the mirror block.

As shown in Figure 2, in an embodiment the substrate holder 20 comprises a core body 21. The core body 21 is a plate-like disk. As shown in Figure 2, in an embodiment the core body 21 comprises a plurality of burls 22. The burls 22 are protrusions protruding at the surface of the core body 21. As shown in Figure 2, in an embodiment the burls 22 have distal ends 23. The core body 21 is configured such that the distal ends 23 are in a support plane 24 for supporting the substrate W. The underside of the substrate W comes into contact with the distal ends 23 of the burls 22. The position of the underside of the substrate W corresponds to the support plane 24. The burls 22 are arranged so that the substrate W lies generally flat on the substrate holder 20. The core body 21 may contain cooling capabilities, for example channels through which cooling liquids can flow, like for example water. In this case the core may consist of multiple layers of material that are bonded to each other by oxidic bond, diffusion bond, or other bonding techniques

The burls 22 are not shown to scale in Figure 2. In a practical embodiment, there can be many hundreds, thousands, or tens of thousands, of burls distributed across a substrate holder 20 of diameter, e.g., 200 mm, 300 mm or 450 mm. The tips of the burls 22 have a small area, e.g. less than 1 mm², so that the total area of all of the burls 22 on one side of the substrate holder 20 is less than about 10% of the total area of the total surface area of the substrate holder 20. Because of the arrangement of burls 22, there is a high probability that any particle that might lie on the surface of the substrate W, substrate holder 20 or substrate table WT will fall between burls 22 and will not therefore result in a deformation of the substrate W or substrate holder 20. The burl arrangement, which may form a pattern, can be regular or can vary as desired to provide appropriate distribution of force on the substrate W and substrate table WT. At a bottom side, there may be far fewer burls (e.g. around 150), which may have a larger surface area than 1 mm2. Both on top and bottom side, a trench may be made around each burl protruding into the core body 21, with as benefit a reduction of lateral stiffness of the burls. This may help to accommodate a changing substrate shape without slipping due to thermal changes due to the heat load of the exposure, and on the bottom side to accommodate deformation of the mirror block (i.e. substrate table body) due to acceleration without slipping. The burls 22 can have any shape in plan but are commonly circular in plan. The burls 22 can have the same shape and dimensions throughout their height but are commonly tapered. The burls 22 can project a distance of from about 1 µm to about 5 mm, desirably from about 5 µm to about 250 µm , desirably about 10 µm above the rest of the object-facing surface of the substrate holder 20 (i.e. the top surface of the electrostatic sheet 25). Hence, the distance between the distal ends 23 of the burls 22 and the top surface of the electrostatic sheet 25 in the vertical direction is from about 1 µm to about 5 mm, desirably from about 5 µm to about 250 µm , desirably about 10 µm. The thickness of the core body 21 of the substrate holder 20 can be in the range of about 1 mm to about 50 mm, desirably in the range of about 5 mm to 20 mm, typically 10 mm.

The core body 21 may be made of rigid material. Desirably the material has a high thermal conductivity and a low coefficient of thermal expansion. Desirably the material is electrically conductive. Desirably the material has a high hardness. A suitable material includes SiC (silicon carbide), SiSiC (siliconized silicon carbide), Si3N4 (silicon nitrite), quartz, and/or various other ceramic and glass- ceramics, such as Zerodur^{™} glass ceramic and/or Cordierite. The core body 21 can be manufactured by selectively removing material from a solid disc of the relevant material so as to leave the projecting burls 22. A suitable technique to remove material includes electrical discharge machining (EDM), etching, machining and or laser ablation. The core body 21 can also be manufactured by growing burls 22 through a mask. The burls 22 may be of the same material as the base and can be grown by a physical vapor deposition process or sputtering. In an embodiment, the core body 21 comprises one or more internal channels (not shown in the Figures). In an embodiment, the core body 21 comprises a plurality of layers that are bonded together. In an embodiment, the layers are formed of different materials. Merely as one example, in an embodiment the core body 21 comprises a layer of SiSiC, a layer of glass and another layer of SiSiC in that order. Other combinations of layers are also possible.

As shown in Figure 2, in an embodiment the substrate holder 20 comprises one or more electrodes 26 for an electrostatic clamp. A potential difference may be generated in order to provide an electrostatic clamping force between the substrate W and the substrate holder 20 and/or between the substrate holder 20 and the substrate stage of the substrate table WT. In an embodiment, the electrodes 26 are encapsulated between dielectric layers (also known as electrical isolation layers) 27, 28. The potential difference generated may for example be of the order of 10 to 5,000 volts, which potential difference may be positive or negative in a polarity thereof. Arrangements using one or more heaters and temperature sensors to locally control the temperature of a substrate are described in U.S. publication no. 2011-0222033, which is incorporated herein by reference in its entirety and the techniques therein may be applied to the techniques herein.

As shown in Figure 2, in an embodiment the substrate holder 20 comprises an electrostatic sheet 25. The electrostatic sheet 25 comprises one or more electrodes 26. For the electrodes 26, in an embodiment two halves of continuous metal film (but isolated from the distal ends 23 of the burls 22) may be separated by a separation distance from each other and positioned to form positive and negative elements of the electrostatic clamp. The separation distance is not particularly limited. In an embodiment the separation distance is at least about 20 µm. In other embodiments, the separation distance is at least about 50 µm , optionally at least about 100 µm , optionally at least about 200 µm , and optionally at least about 500 µm . In an embodiment the separation distance is at most about 2 mm, optionally at most about 1 mm, and optionally at most about 500 µm . In an embodiment the separation distance is about 500 µm . There may therefore be two electrodes 26. However, the number of electrodes 26 in the electrostatic sheet 25 is not particularly limited and may be one or three or more. For example, for clamping of a substrate with an insulating backside, one may need two electrodes at minimum. One of the electrodes may be set at a positive voltage and the other may be set at a negative voltage. In this way, the substrate may not need to be grounded but is clamped nevertheless while on average being at a potential near ground (0V). For application of an electrode on the bottom side of the clamp, to clamp to the mirrorblock, one electrode may suffice, as one may ground a conducting coating on the mirrorblock, and in this way have a voltage difference between clamp electrode and mirrorblock to create the force

Metal lines of the electrodes 26 may have a layer thickness greater than about 20 nm, desirably greater than about 40 nm. The metal lines desirably have a layer thickness less than or equal to about 1pm, desirably less than about 500 nm, desirably less than about 200 nm.

An electrode 26 of an upper electrostatic sheet 25 may be configured to electrostatically clamp the substrate W to the substrate holder 20. An electrode 26 of a lower electrostatic sheet 25 may be configured to electrostatically clamp the substrate holder 20 to the rest of the substrate table WT.

In an embodiment the material of the core body 21 and the burls 22 is electrically conductive. For example, in an embodiment the material of the burls 22 is SiSiC. However, it is not essential for the material of the core body 21 and the burls 22 to be electrically conductive. In an embodiment, a grounding layer may be provided that electrically connects the distal ends 23 of two or more of the burls 22 (optionally all of the burls 22) to ground or a common electrical potential. The grounding layer may be formed by depositing a relatively thick layer of a conductive material. The conductive material is not particularly limited. In an embodiment the conductive material is Cr. In an alternative embodiment the conductive material is CrN. In an embodiment the deposited layer is then patterned to form the grounding layer. The pattern may comprise a series of metal lines that connect together distal ends 23 of the burls 22. Such patterns are sometimes referred to as "Manhattan" patterns. In an alternative embodiment the deposited layer is not patterned. In an embodiment the grounding layer or another layer is arranged to cover a surface of the core body 21 and/or the burls 22. The grounding layer or other layer can help to smoothen the surface to make it easier to clean the surface.

As shown in Figure 2, in an embodiment the electrostatic sheet 25 comprises an electrode 26 sandwiched between dielectric layers 27, 28. As shown in Figure 2, in an embodiment burls 22 and the electrostatic sheet 25 are provided on both main surfaces of the substrate holder 20. In an alternative embodiment, the burls 22 and the electrostatic sheet 25 are provided on only one of the two main surfaces of the substrate holder 20. As shown in Figure 2, in an embodiment the electrostatic sheet 25 is between the burls 22. For example, as shown in Figure 2, holes are 34 are provided in the electrostatic sheet 25. The holes 34 are arranged such that their position corresponds to the burls 22 of the core body 21. The burls 22 protrude through respective holes 34 of the electrostatic sheet 25 such that the electrode 26 that is sandwiched between the dielectric layers 27, 28 is provided in the region between the burls 22.

As shown in Figure 2, in an embodiment the substrate holder 20, comprises a bonding material 29. In an embodiment, the bonding material has a thickness of at least 100 nm. The bonding material 29 secures the position of the electrostatic sheet 25 relative to the core body 21. The bonding material 29 keeps the holes 34 in the electrostatic sheet 25 aligned with the burls 22. In an embodiment, the burls 22 are positioned at the centre of respective holes 34 of the electrostatic sheet 25. By providing that the bonding material 29 has a thickness of at least 100nm, a minimum level of compliancy of the bond layer is ensured. In general, thicker bonding material is more compliant and less sensitive to stress levels caused by temperature differences at the interface between the core body 21 and the electrostatic sheet 25. In an embodiment, the bonding material 29 has a thickness of at least 2 micrometers. In another embodiment, the bonding material 29 has a thickness of at least 200nm, optionally at least 500nm, optionally at least lpm, , optionally at least 5pm, optionally at least 10pm, optionally at least 20pm, optionally at least 25pm and optionally at least 50pm. The inventors have found that making the bonding material 29 at least 25pm in thickness improves the tolerances of the interface parts to temperature differences (i.e. the bond layer is more compliant). In an embodiment, the bonding material 29 has a thickness of at most 100pm. This ensures a minimum level of stability of the bonding material 29, which is beneficial for the electrostatic performance of the clamping function. In an embodiment, the bonding material 29 has a thickness of at most 75pm, and optionally at most 50pm. Reducing the thickness of the bonding material 29 helps to make the bonding material 29 more stable. Merely as an example, in an embodiment the bonding material 29 has a thickness in the range of from about 25pm to about 75pm.

As shown in Figure 2, in an embodiment the bonding material 29 is formed in discrete portions that do not connect to each other. For example, 1000's of glue dots may be provided that are located between burls. The glue dots may be placed on specific pads machined in the core 21. There may be some variation in the thickness of the different portions of bonding material 29. In an embodiment, the separate portions of bonding material 29 have substantially the same thickness as each other. As shown in Figure 10, in an alternative embodiment the bonding material 29 extends continuously in the region between the core body 21 and the electrostatic sheet 25. As shown in Figure 10, in an embodiment the bonding material 29 extends to the region between the electrostatic sheet 25 and the burls 22.

Figures 3-5 schematically depict successive stages of a process of manufacturing the substrate holder 20. In particular, Figures 3-5 show stages of joining the electrostatic sheet 25 to the core body 21

As shown in Figure 3, in an embodiment the method of manufacturing the substrate holder 20 comprises providing a core body 21. The core body 21 comprises a plurality of burls 22 for supporting the substrate W. As shown in Figure 3, in an embodiment the method comprises applying bonding material 29 to the core body 21. The bonding material 29 is applied at least to one of the main surfaces of the core body 21. The bonding material 29 is applied between the burls 22. As shown in Figure 3, in an embodiment a plurality of discrete portions of bonding material 29 are applied to the core body 21. In an alternative embodiment, the bonding material 29 is applied substantially continuously across the main surface of the core body 21 between the burls 22. The method for dispensing the bonding material 29 is not particularly limited. By providing a plurality of discrete portions of bonding material 29, the overall volume of the bonding material 29 may be reduced. This reduces the possibility of excess bonding material 29 being present near the burls 22 which may otherwise adversely influence the clamping function of the substrate holder 20.

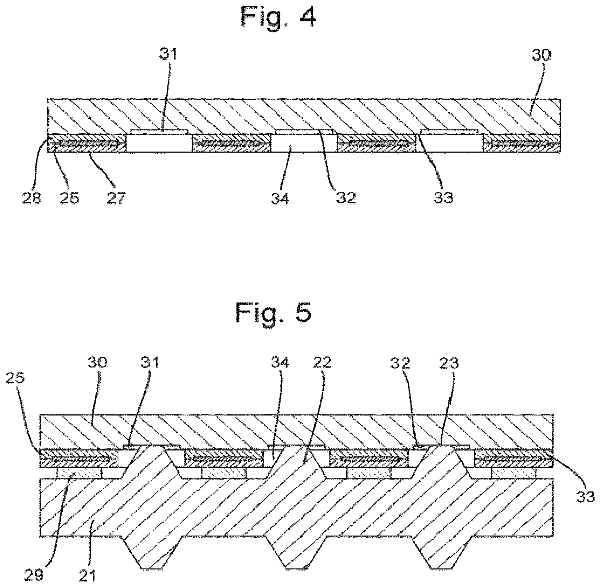

As shown in Figure 4, in an embodiment the method comprises connecting an electrostatic sheet 25 to a plate 30 of a tool. The plate 30 comprises a plurality of recesses 31 for respective burls 22 of the core body 21. The recesses 31 line up with respective holes 34 of the electrostatic sheet 25. In an embodiment, the centers of the recesses 31 align with the centers of the holes 34 in the electrostatic sheet 25. The plate 30 is configured such that the pattern of recesses 31 corresponds to the pattern of burls 22 of the core body 21. Accordingly, the disclosure provided above regarding the number and the positioning of the burls 22 applies equally to the number and positioning of the recesses 31 of the plate 30, as well as to the holes 34 of the electrostatic sheet 25. In an embodiment, in a direction perpendicular to a plane of the plate 30, the plate 30 has a stiffness of at most 10⁵ Nm⁻¹. The plate 30 is configured to be compliant to follow variations in the heights of the burls 22.

The way that the plate 30 is connected to the electrostatic sheet 25 is not particularly limited. For example, the connection between the plate 30 and the electrostatic sheet 25 may be by means of a vacuum and/or electrostatic attraction and/or temporary bonding. One means of electrostatic attraction could be by application of an electric potential (voltage) between plate 30 and sheet 25. In an embodiment, the plate 30 is positioned with respect to the core body 21 , for example using a positioner. The positioner is configured to control movement of the plate 30 when the electrostatic sheet 25 is connected. The positioner positions the plate 30 relative to the core body 21 such that the recesses 31 of the plate 30 (and hence also the holes 34 of the electrostatic sheet 25) are aligned with the burls 22 of the core body 21.

The positioner is configured to control movement of the plate 30 so as to mount the electrostatic sheet 25 onto the core body 21 between the burls 22. For example, the positioner may lower the plate 30 downwards onto the core body 21. In an alternative embodiment, the positioner is configured to move the core body 21 upwards towards the plate 30 such that the burls 22 extend through the holes 34 of the electrostatic sheet 25.

During the mounting process, the distal ends 23 of the burls 22 come into contact with the base of the recesses 31. The base of the recesses 31 stops the electrostatic sheet 25 and the core body 21 from moving closer to each other. The depth of the recesses 31 determines the height at which the electrostatic sheet 25 is mounted. The depth of the recesses 31 controls the distance between the bottom of the electrostatic sheet 25 and the upper surface of the core body 21 (where the bonding material 29 is positioned). The depths of the recesses 31 controls the height that the burls 22 protrude above the upper surface of the electrostatic sheet 25 in the manufactured substrate holder 20.

In an embodiment, the recesses 31 have a depth that corresponds to the projected distance of the burls 22 mentioned above. For example, the recesses 31 have a depth of about 1 µm to about 5mm, desirably from about 5 µm to about 250 µm.

In an embodiment, the method of manufacturing the substrate holder 20 comprises a step of curing the bonding material 29. In an embodiment, the bonding material 29 is cured under vacuum. This helps to avoid inclusions in the bonding material 29. However, it is not essential for the bonding material 29 to be cured. In an alternative embodiment, the bonding material 29 does not need to be cured.

The type of bonding material used is not particularly limited. In an embodiment the bonding material 29 comprises an adhesive material. However, it is not essential for the bonding material 29 to be an adhesive material. Non-adhesive materials can also be used. For example, in an alternative embodiment, the bonding material 29 is a material used in soldering or welding the electrostatic sheet 25 to the core body 21, or a solder glass, or a frit glass.

Figure 5 schematically shows the moment when the distal ends 23 of the burls 22 abut against the base of the recesses 31. The recesses may also be formed on a flat plate by depositing a coating on the locations that need to be raised. For example, for 10 um, plural coatings may be employed.

The electrostatic sheet 25 of the object holder as described above with reference to Figures 2 - 5 may comprise two glass layers forming the dielectric layers, with an electrically conductive coating in between, such as a Chromium coating on one of the glass layers. For example, the electrically conductive coating may be arranged on a lower side of the upper glass layer.

In the object holder described above, the electrostatic sheet may be brittle, as it is made of glass layers. For example, a particle, such as a dust particle, between the object held by the object holder and the electrostatic sheet may exert a high force onto a contacting area of the electrostatic sheet, where the particle contacts the electrostatic sheet, which may promote a risk of cracking of one or both of the glass layers. Moreover, given the high electrical voltage applied to the conductive coating in between the glass layers, and the consequential high voltage difference towards the burls, a risk of dielectric breakthrough may be enhanced in case such a cracking would occur.

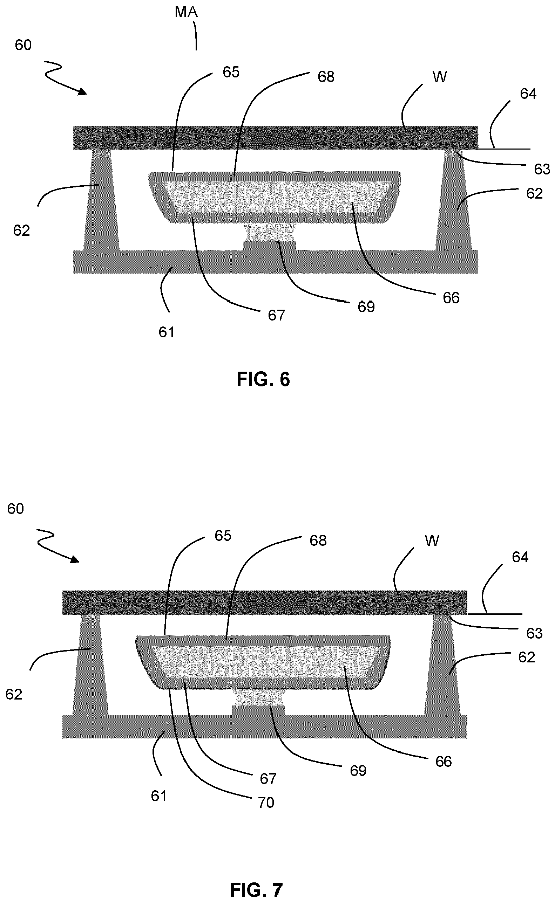

Figure 6 depicts an enlarged view of a part of a substrate holder 60 according to an embodiment of the present invention. As shown in Figure 6, in an embodiment the substrate holder 60 comprises a core body 61. The core body 61 may be a plate-like disk which comprises a plurality of burls 62 which form protrusions protruding from a surface of the core body 61. Distal ends 63 of the burls 62 have are arranged in a support plane 64 for supporting the substrate W.

Although Figure 6 only shows 2 burls, in a practical embodiment, there can be many hundreds, thousands, or tens of thousands, of burls distributed across a substrate holder 60 mm. Accordingly, the view of Figure 6 may be understood to depict a part of the substrate holder only. In an embodiment, the electrode may be shaped as a colander, with 1000's of holes where one burl protrudes through each hole

For further features of the core body 61, reference is made to the core body 21 as depicted in and described above with reference to Figure 2.

Likewise to the substrate holder 20 as depicted in and described with reference to Figure 2, substrate holder 60 as depicted in Figure 6 comprises one or more electrodes 66 for an electrostatic clamp. A potential difference may be generated in order to provide an electrostatic clamping force between the substrate W and the substrate holder 60 and/or between the substrate holder 60 and the substrate stage of the substrate table WT. In an embodiment, the electrodes 66 are encapsulated with a dielectric layer 67, 68. The potential difference generated may for example be of the order of 10 to 5,000 volts.

In accordance with an aspect of the present invention, the electrodes comprise a metal and the dielectric layers comprise metal oxide layers, the metal oxide being an oxide of the metal. The electrostatic sheet may hence comprise metal oxide layers and an electrode sandwiched between the metal oxide layers, wherein the electrode comprises a metal and wherein the metal oxide comprises an oxide of the metal. The electrostatic sheet comprising metal oxide layers and an electrode sandwiched between the metal oxide layers, wherein the electrode comprises a metal and wherein the metal oxide comprises an oxide of the metal, may be strong. Hence, the electrostatic sheet may be less susceptible to cracking, as compared to the glass layers of the electrostatic sheet described with reference to Figure 2. Further, as the metal oxide of the metal oxide layers comprises an oxide of the same metal as the metal of the electrode, a strong bonding between the electrode and the metal oxide layers may be provided, hence promoting a strength of the electrostatic sheet.

In an embodiment, the metal comprises at least one of aluminum, titanium and magnesium. The metal may comprise a pure form of aluminum, titanium or magnesium, or any alloy of aluminum, titanium or magnesium. These metals, as well as alloys thereof, may be oxidized by Plasma Electrolytic Oxidation, PEO, enabling to manufacture a highly crack resistant sandwich structure as the metal and metal oxide may from which the sandwich structure is formed may be manufactured from a single sheet of metal as a starting point, oxidizing the outer surfaces thereof, hence providing a strong bonding between the electrode and the dielectric layers. In the case of an aluminum plate that is oxidized with 100 micrometer Al2O3 on both sides, the aluminum does not have to be extremely thin. By having an aluminum plate with a relatively high thickness (200 to 1000 micrometer), one may obtain a robust substrate holder that is resistant against damage from particles that are compressed between wafer and e-sheet.

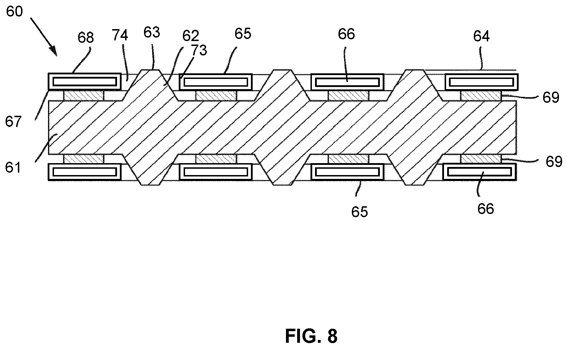

In an embodiment, as will be explained below with reference to Figure 8, the electrostatic sheet 65 comprises a plurality of through holes 74, the burls 62 extending through the through holes, wherein edges 73 of the through holes are covered by metal oxide extending between the metal oxide layers.

In an embodiment, a pitch of the through holes of the electrostatic sheet matches a pitch of the burls such that the burls line up with the through holes in the electrostatic sheet.

In an embodiment, the electrostatic sheet extends substantially parallel to the support plane, so as to promote a evenly distributed electrostatic clamping force because of a same distance between the electrostatic sheet and the support plane, i.e. the substrate or wafer held by the substrate holder.

Figure 7 depicts an enlarged view of a part of an object holder according to another embodiment of the present invention. As depicted in Figure 7, an outer surface of the electrostatic sheet facing away from the support plane is coated by an electrically conductive coating 70. The electrically conductive coating may be configured to be connected to ground or other suitable electrical potential. The electrostatic sheet may thereby be shielded from the core body 61, which may be electrically grounded or held at another suitable potential, the shielding preventing or a least reducing an interaction by electrostatic force between the electrostatic sheet and the core body. Thereby a force on the glue 69 between the electrostatic sheet and the core body may be reduced which may contribute to a usable lifetime of the glue 69. This also may prevent electrostatic interactions at the bottom side. The force on the glue may be increased because of the shielding. Without shielding, the electrode may be pulled towards the substrate as well as toward the core body. With the shielding, the electrode may only be pulled towards the substrate, and this force may therefore also be on the glue dots. The force may for example be of the order of 10-100 kN/m2 or 0.1-1 bar

The object holder in accordance with Figure 7 further corresponds to the object holder in accordance with Figure 6. The same reference numerals refer to the same of similar items, the description to Figure 6 likewise being applicable to the embodiment as depicted in Figure 7.

In an embodiment, the aluminum oxide layers are coated by PolyEtherEtherKetone, PEEK. The PEEK coating may fill pores in the dielectric layers comprising the metal oxide, hence may contribute to a reduction of arcing at such pores.

In an embodiment, a thickness of the metal oxide layers is between 50 and 150 micrometers, providing for a relatively thin layer with suitable dielectric properties, enabling a relatively short distance between the electrode on the one hand and the substrate on the other hand, hence enabling to build-up a high clamping force.

In an embodiment, a thickness of the electrode is between 300 and 500 micrometers. The relatively thick electrode comprising the metal may provide for a mechanically strong electrode, thereby promoting a mechanical ruggedness of the electrostatic sheet as a whole and promoting an ability of the electrostatic sheet to resist against cracking.

In an embodiment, a distance between the support plane and an outer surface of the electrostatic sheet facing the support plane is between 1 micrometers and 20 micrometers. In particular in combination with the above mentioned feature of a thickness of the metal oxide layers between 50 and 150 micrometers, a high clamping force may be generated.

In an embodiment, the substrate holder is provided with a further electrostatic clamp which enables a surface of the clamp which is parallel to and facing away from the support surface, to clamp to another structure, e.g. another structure of the lithographic apparatus. Accordingly, in such embodiment, the core body comprises a plurality of further burls having distal ends in a plane of the substrate table for supporting the substrate holder on a body of the substrate table; and
a further electrostatic sheet between the further burls, the further electrostatic sheet comprising metal oxide layers and an electrode sandwiched between the metal oxide layers;
wherein the mirror block plane is parallel to the support plane.

In an embodiment, the metal of the electrode of the further electrostatic sheet comprises aluminum and wherein the metal oxide comprises aluminum oxide. Alternatively, the metal may comprise titanium or magnesium, as described above.

In the above, the object holder has been explained, taking a substrate holder as an example, such as a wafer holder. The object holder as described in the present document may further be a patterning device holder configured to hold a patterning device, such as a mask.

Figure 8 depicts a cross-sectional view of an object holder 60 in accordance with the present invention. The object holder 60 is configured to support an object. In the description below, the invention will be described in a context of the object holder being a substrate holder 60 that is configured to support a substrate W. However, the object holder is not limited to such a substrate holder 60. For example, the object holder may be configured to support a patterning device MA, such as a mask.

In an embodiment, the substrate Table WT comprises the substrate holder 60 and a substrate stage. For example, the substrate stage comprises a recess into which the substrate holder 60 is held. The substrate holder 60 is configured to hold the substrate W relative to the substrate stage of the substrate table WT. As another example, the mirror block of the substrate stage may have a flat top without cutout for the clamp. The bottom electrode of the clamp may exert a clamping force on the mirror block to hold the clamp in place on the mirror block.

As shown in Figure 8, in an embodiment the substrate holder 60 comprises a core body 61. The core body 61 is a plate-like disk. As shown in Figure 8, in an embodiment the core body 61 comprises a plurality of burls 62. The burls 62 are protrusions protruding at the surface of the core body 61. As shown in Figure 8, in an embodiment the burls 62 have distal ends 63. The core body 61 is configured such that the distal ends 63 are in a support plane 64 for supporting the substrate W. The underside of the substrate W comes into contact with the distal ends 63 of the burls 62. The position of the underside of the substrate W corresponds to the support plane 64. The burls 62 are arranged so that the substrate W lies generally flat on the substrate holder 60.

The burls 62 are not shown to scale in Figure 8. In a practical embodiment, there can be many hundreds, thousands, or tens of thousands, of burls distributed across a substrate holder 60 of diameter, e.g., 200 mm, 300 mm or 450 mm. The tips of the burls 62 have a small area, e.g. less than 1 mm2, so that the total area of all of the burls 62 on one side of the substrate holder 60 is less than about 10% of the total area of the total surface area of the substrate holder 60. Because of the arrangement of burls 62, there is a high probability that any particle that might lie on the surface of the substrate W, substrate holder 60 or substrate table WT will fall between burls 62 and will not therefore result in a deformation of the substrate W or substrate holder 60. The burl arrangement, which may form a pattern, can be regular or can vary as desired to provide appropriate distribution of force on the substrate W and substrate table WT. The burls 62 can have any shape in plan but are commonly circular in plan. The burls 62 can have the same shape and dimensions throughout their height but are commonly tapered. The burls 62 can project a distance of from about 1 micrometers to about 20 micrometers above the rest of the object-facing surface of the substrate holder 60 (i.e. the top surface of the electrostatic sheet 65). Hence, the distance between the support plane formed by the distal ends 63 of the burls 62 and the top surface of the electrostatic sheet 65 in the vertical direction is from about 1 micrometers to about 20 micrometers. The thickness of the core body 61 of the substrate holder 20 can be in the range of about 1 mm to about 50 mm, desirably in the range of about 5 mm to 20 mm, typically 10 mm. The burls may be coated with a coating to create preferable mechanical properties for substrate contact, such as a hard wearing material with specific friction coefficient and resilience against damage resulting from particles between substrate and burl.

The core body 61 may be made of rigid material. Desirably the material has a high thermal conductivity or a low coefficient of thermal expansion. Desirably the material is electrically conductive. Desirably the material has a high hardness. A suitable material includes SiC (silicon carbide), SiSiC (siliconized silicon carbide), Si3N4 (silicon nitrite), quartz, and/or various other ceramic and glass-ceramics, such as Zerodur^{™} glass ceramic and/or Cordierite. The core body 61 can be manufactured by selectively removing material from a solid disc of the relevant material so as to leave the projecting burls 62. A suitable technique to remove material includes electrical discharge machining (EDM), etching, machining and or laser ablation. The core body 61 can also be manufactured by growing burls 62 through a mask. The burls 62 may be of the same material as the base and can be grown by a physical vapor deposition process or sputtering. In an embodiment, the core body 61 comprises one or more internal channels (not shown in the Figures). In an embodiment, the core body 61 comprises a plurality of layers that are bonded together. In an embodiment, the layers are formed of different materials. Merely as one example, in an embodiment the core body 61 comprises a layer of SiSiC, a layer of glass and another layer of SiSiC in that order. Other combinations of layers are also possible.

As shown in Figure 8, in an embodiment the substrate holder 60 comprises one or more electrodes 66 for an electrostatic clamp. A potential difference may be generated in order to provide an electrostatic clamping force between the substrate W and the substrate holder 60 and/or between the substrate holder 60 and the substrate stage of the substrate table WT. In an embodiment, the electrodes 66 are encapsulated between dielectric layers (also known as electrical isolation layers) 7, 28. The potential difference generated may for example be of the order of 10 to 5,000 volts.

As shown in Figure 8, the substrate holder 60 comprises an electrostatic sheet 65. The electrostatic sheet 65 comprises one or more electrodes 66 which comprise a metal. For the electrodes 66, in an embodiment two halves of electrodes 66 (but isolated from the distal ends 63 of the burls 62) may be separated by a separation distance from each other and deposited to form positive and negative elements of the electrostatic clamp. The separation distance is not particularly limited. There may therefore be two electrodes 66. However, the number of electrodes 66 in the electrostatic sheet 65 is not particularly limited and may be one or three or more. The electrode 66 may have a thickness of between 300 and 500 micrometers.

An electrode 66 of an electrostatic sheet 65 may be configured to electrostatically clamp the substrate W to the substrate holder 60. A further electrostatic clamp may be formed by the further burls 62 and further electrode 66 arranged at a lower side of the object holder. The further electrode 66 of a further electrostatic sheet 65 may be configured to electrostatically clamp the substrate holder 60 to the rest of the substrate table WT, e.g. to a mirror block thereof.

In an embodiment the material of the core body 61 and the burls 62 is electrically conductive. For example, in an embodiment the material of the burls 62 is SiSiC. However, it is not essential for the material of the core body 61 and the burls 62 to be electrically conductive. In an embodiment, a grounding layer may be provided that electrically connects the distal ends 63 of two or more of the burls 62 (optionally all of the burls 62) to ground or a common electrical potential. The grounding layer may be formed by depositing a relatively thick layer of a conductive material. The conductive material is not particularly limited.

As shown in Figure 8, in an embodiment the electrostatic sheet 65 comprises an electrode 66 comprising a metal sandwiched between dielectric layers 67, 68 comprising an oxide of the metal. For example, the electrostatic sheet may comprise aluminum and the dielectric layers may comprise aluminum oxide. As another example, the electrostatic sheet may comprise magnesium and the dielectric layers may comprise magnesium oxide. As yet another example, the electrostatic sheet may comprise titanium and the dielectric layers may comprise titanium oxide. The structure of an electrode comprising a metal, sandwiched between the metal oxide layers comprising the oxide of the metal, may form a mechanically stable structure that is less susceptible to cracking when placed under mechanical stress, such as by a dust particle between the electrostatic sheet and the substrate, or during manufacturing of the substrate holder. The metal oxide layers may have a thickness between 50 micrometers and 150 micrometers. The formation of the oxide may be conformal over the entire surface including over the edge of any holes in the plate.

The metal oxide layers may be coated by PolyEtherEtherKetone, PEEK to fill gaps, holes etc. in the metal oxide, thereby making the metal oxide layers less susceptible to arcing when in use an electrostatic voltage is applied to the electrode of the electrostatic sheet.

Likewise as described above with reference to Figure 7, the outer surface of the electrostatic sheet 65 as depicted in Figure 8, which outer surface facing away from the support plane, i.e. facing the core body 61, is provided with an electrically conductive coating which may be grounded for shielding purpose, thereby e.g. to provide a shield between the electrode and the core body.

As shown in Figure 8, in an embodiment burls 62 and the electrostatic sheet 65 are provided on both main surfaces of the substrate holder 60. In an alternative embodiment, the burls 62 and the electrostatic sheet 65 are provided on only one of the two main surfaces of the substrate holder 60.

As shown in Figure 8, in an embodiment the electrostatic sheet 65 is between the burls 62. For example, as shown in Figure 8, through holes are provided in the electrostatic sheet 65. The through holes 74 are arranged such that their position corresponds to the burls 62 of the core body 61. The burls 62 protrude through respective through holes 74 of the electrostatic sheet 65 such that the electrode 66, which electrode is sandwiched between the dielectric layers 67, 68, is provided in the region between the burls 62. Edges 73 of the through holes, i.e. edges facing the burls, are covered by the metal oxide, such as the aluminum oxide, the magnesium oxide or the titanium oxide mentioned above to form a dielectric between the electrode and the burls.

As shown in Figure 8, in an embodiment the substrate holder 60, comprises a bonding material 69. The bonding material 69 secures the position of the electrostatic sheet 65 relative to the core body 61. The bonding material 69 keeps the through holes 74 in the electrostatic sheet 65 aligned with the burls 62. In an embodiment, the burls 62 are positioned at the center of respective through holes 74 of the electrostatic sheet 65.

An object table according to an aspect of the invention comprises a supporting member and the object holder according to the present invention, the object holder is attached to the supporting member. The supporting member may for example comprise a mirror block of a lithographic apparatus.

A lithographic apparatus according to yet another aspect of the invention is arranged to project a pattern from a patterning device onto a substrate, the lithographic apparatus comprises the object holder according to the present invention or the object table according to the present invention. The object may for example be a substrate or a patterning device, such as a mask. The lithographic apparatus may be a lithographic apparatus as described with reference to Figure 1.

The object holder as described above may be manufactured as follows. A metal sheet comprising a metal is providing and a plurality of through holes are created in the metal sheet. The through holes may be created in the metal sheet by at least one of: - sand blasting, - electron beam drilling, and - CNC machining to form relatively small through holes in the metal at a high precision. Other possibilities to create the through holes in the metal sheet comprise laser beam shaping or laser beam etching, whereby a laser beam affects the material such that it subsequently is removed with a mild etchant.

Metal oxide layers are provided on the metal sheet to form an electrostatic sheet, the metal oxide layers comprising an oxide of the metal. The metal oxide layers may be provided on the metal sheet by oxidizing outer surfaces of the aluminum sheet to form the metal oxide layers. Thereby, the metal oxide layers and the metal sheet may be manufactured from a same piece of material, providing a highly mechanically stable electrostatic sheet. The electrostatic sheet may be mechanically more rugged and less susceptible to cracking, i.e. which may be advantageous in a remainder of the manufacturing process and handling of the electrostatic sheet. The oxidizing may comprise Plasma Electrolytic Oxidation, PEO. The oxide layer's thickness may be finely controlled, enabling to adapt resulting characteristics to the application. For example, thickening the oxide layer increases the dielectric strength. For example, aluminum oxide, the main component of the PEO surface layer on an aluminum alloy, has dielectric strengths ranging from 14.6-16.7 kV/mm. Another benefit of aluminum oxide may be that it has a dielectric constant of about 7.5-9.4 which is 50-100% higher than glass. As a result, the electrode may be operated at substantially lower voltages while retaining the desired clamp force. A silica additive may be used. Is the silica additive added to the metal alloy, i.e. before the oxidation? Aluminum with a PEO surface coating that includes silica additives have dielectric strengths of 59-79 kV/mm. The silica additives may according enable to obtain 5.9-7.9 kV on 100 um layer thickness. As an alternative to PED, other oxidation processes may be applied, such micro-arc oxidation, MAO, in NaAlO2 solution which may provide for e.g. 40-100 um Al2O3 out of Al.

The metal oxide layers ay be coated by PolyEtherEtherKetone, PEEK. The coating may fill pores in the dielectric layers comprising the metal oxide, which may promote a reduction of arcing at these pores.

In order to shield the core body from being subjected to the electrostatic field, when in operation, one surface of the electrostatic sheet may be coated by an electrically conductive coating.

Furthermore, in the manufacturing process, a core body is provided comprising a plurality of burls having distal ends in a support plane for supporting the object.

The electrostatic sheet and the core body are assembled to form the object holder. The assembling the electrostatic sheet and the core body may comprises assembling the electrostatic sheet and the core body whereby the one surface of the electrostatic sheet coated by the electrically conductive coating, in assembled state, faces away from the support plane.

As noted above, in an embodiment, the metal comprises one of aluminum, magnesium and titanium and the metal oxide comprises an oxide of the one of aluminum, magnesium and titanium. The metals aluminum, magnesium and titanium may be oxidized by Plasma Electrolytic Oxidation to form the oxide layers on the electrode.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. An object holder configured to support an object, the object holder comprising:
   a core body comprising a plurality of burls having distal ends in a support plane for supporting the object;
      and
   an electrostatic sheet between the burls, the electrostatic sheet comprising
      an electrode comprising a metal, and
      metal oxide layers comprising an oxide of the metal,
      wherein the electrode is sandwiched between the metal oxide layers.
2. The object holder according to example 1, wherein the metal comprises at least one of aluminum, titanium and magnesium.
3. The object holder according to example 1 or 2, wherein the electrostatic sheet comprises a plurality of through holes, the burls extending through the through holes, wherein edges of the through holes are covered by metal oxide extending between the metal oxide layers.
4. The object holder according to example 3, wherein a pitch of the through holes of the electrostatic sheet matches a pitch of the burls such that the burls line up with the through holes in the electrostatic sheet.
5. The object holder according to any one of the preceding examples, wherein the electrostatic sheet extends substantially parallel to the support plane
6. The object holder according to any one of the preceding examples, wherein an outer surface of the electrostatic sheet facing away from the support plane is coated by an electrically conductive coating.
7. The object holder according to any one of the preceding examples, wherein aluminum oxide layers are coated by PolyEtherEtherKetone, PEEK.
8. The object holder according to any one of the preceding examples, wherein a thickness of the metal oxide layers is between 50 and 150 micrometers.
9. The object holder according to any one of the preceding examples, wherein a thickness of the electrode is between 300 and 500 micrometers.
10. The object holder according to any one of the preceding examples, wherein a distance between the support plane and an outer surface of the electrostatic sheet facing the support plane is between 1 micrometers and 20 micrometers.
11. The object holder according to any one of the preceding examples, wherein the core body comprises a plurality of further burls having distal ends in a mirror block plane for supporting the substrate holder on a mirror block; and
   a further electrostatic sheet between the further burls, the further electrostatic sheet comprising metal oxide layers comprising an oxide of the metal and an electrode sandwiched between the metal oxide layers;
   wherein the mirror block plane is parallel to the support plane.
12. The object holder according to any one of the preceding examples, wherein the metal comprises at least one of aluminum, titanium and magnesium.
13. The object holder according to any one of the preceding examples, wherein the object holder is one of a substrate holder configured to hold a substrate and a patterning device holder configured to hold a patterning device.
14. An object table comprising a supporting member and the object holder according to any one of the preceding examples, the object holder being attached to the supporting member.
15. A lithographic apparatus arranged to project a pattern from a patterning device onto a substrate, the lithographic apparatus comprising the object holder according to any one of examples 1 - 13 or the object table according to example 14.
16. A method of manufacturing an object holder, comprising:
   providing a metal sheet comprising a metal,
   creating a plurality of through holes in the metal sheet,
   providing metal oxide layers on the metal sheet to form an electrostatic sheet, the metal oxide layers comprising an oxide of the metal,
   providing a core body comprising a plurality of burls having distal ends in a support plane for supporting the object, and
   assembling the electrostatic sheet and the core body to form the object holder.
17. The method according to example 16, wherein the providing metal oxide layers on the metal sheet comprises oxidizing outer surfaces of the aluminum sheet to form the metal oxide layers.
18. The method according to example 17, wherein the oxidizing comprising Plasma Electrolytic Oxidation, PEO.
19. The method according to any one of examples 16 - 18, further comprising coating the metal oxide layers by PolyEtherEtherKetone, PEEK.
20. The method according to any one of example 16 - 19, wherein the through holes are created in the metal sheet by at least one of:
   - sand blasting,
   - electron beam drilling,
   - CNC machining,
   - laser beam shaping, and
   - laser beam etching.
21. The method according to any one of examples 16 - 20, further comprising coating one surface of the electrostatic sheet by an electrically conductive coating, and wherein the assembling the electrostatic sheet and the core body comprises assembling the electrostatic sheet and the core body whereby the one surface of the electrostatic sheet coated by the electrically conductive coating, in assembled state, faces away from the support plane.
22. The method according to any one of examples 16 - 21, wherein the metal comprises at least one of aluminum, titanium and magnesium.
23. The method according to any one of examples 16 - 22, wherein the object holder is one of a substrate holder configured to hold a substrate and a patterning device holder configured to hold a patterning device.

## Claims

1. An object holder configured to support an object, the object holder comprising:
a core body comprising a plurality of burls having distal ends in a support plane for supporting the object;
and
an electrostatic sheet between the burls, the electrostatic sheet comprising
an electrode comprising a metal, and
metal oxide layers comprising an oxide of the metal,
wherein the electrode is sandwiched between the metal oxide layers.

2. The object holder according to claim 1, wherein the metal comprises at least one of aluminum, titanium and magnesium.

3. The object holder according to claim 1 or 2, wherein the electrostatic sheet comprises a plurality of through holes, the burls extending through the through holes, wherein edges of the through holes are covered by metal oxide extending between the metal oxide layers.

4. The object holder according to claim 3, wherein a pitch of the through holes of the electrostatic sheet matches a pitch of the burls such that the burls line up with the through holes in the electrostatic sheet.

5. The object holder according to any one of the preceding claims, wherein the electrostatic sheet extends substantially parallel to the support plane

6. The object holder according to any one of the preceding claims, wherein an outer surface of the electrostatic sheet facing away from the support plane is coated by an electrically conductive coating.

7. The object holder according to any one of the preceding claims, wherein aluminum oxide layers are coated by PolyEtherEtherKetone, PEEK.

8. The object holder according to any one of the preceding clams, wherein a thickness of the metal oxide layers is between 50 and 150 micrometers.

9. The object holder according to any one of the preceding claims, wherein a thickness of the electrode is between 300 and 500 micrometers.

10. The object holder according to any one of the preceding claims, wherein a distance between the support plane and an outer surface of the electrostatic sheet facing the support plane is between 1 micrometers and 20 micrometers.

11. The object holder according to any one of the preceding claims, wherein the core body comprises a plurality of further burls having distal ends in a mirror block plane for supporting the substrate holder on a mirror block; and
a further electrostatic sheet between the further burls, the further electrostatic sheet comprising metal oxide layers comprising an oxide of the metal and an electrode sandwiched between the metal oxide layers;
wherein the mirror block plane is parallel to the support plane.

12. The object holder according to any one of the preceding claims, wherein the metal comprises at least one of aluminum, titanium and magnesium.

13. The object holder according to any one of the preceding claims, wherein the object holder is one of a substrate holder configured to hold a substrate and a patterning device holder configured to hold a patterning device.

14. A lithographic apparatus arranged to project a pattern from a patterning device onto a substrate, the lithographic apparatus comprising the object holder according to any one of claims 1 - 13.

15. A method of manufacturing an object holder, comprising:
providing a metal sheet comprising a metal,
creating a plurality of through holes in the metal sheet,
providing metal oxide layers on the metal sheet to form an electrostatic sheet, the metal oxide layers comprising an oxide of the metal,
providing a core body comprising a plurality of burls having distal ends in a support plane for supporting the object, and
assembling the electrostatic sheet and the core body to form the object holder.
